(19) **Europäisches Patentamt**
**European Patent Office**
**Office européen des brevets**

(11) **EP 2 377 143 B1**

(12) **EUROPEAN PATENT SPECIFICATION**

(45) Date of publication and mention
of the grant of the patent:
**01.04.2020 Bulletin 2020/14**

(51) Int Cl.:
$H01J\ 49/16$ (2006.01)
$H01J\ 27/24$ (2006.01)
$G21G\ 1/10$ (2006.01)
$H05H\ 6/00$ (2006.01)

(21) Application number: **09796829.1**

(22) Date of filing: **20.12.2009**

(86) International application number:
**PCT/IL2009/001201**

(87) International publication number:
**WO 2010/070648 (24.06.2010 Gazette 2010/25)**

(54) **A SYSTEM FOR GENERATION OF FAST IONS AND A METHOD THEREFOR**

SYSTEM FÜR THE ERZEUGUNG VON SCHNELLEN IONEN UND METHODE DAFÜR

UN SYSTÈME POUR LA GÈNÉRATION D'IONS RAPIDES ET UNE MÉTHODE PUR CECI

(84) Designated Contracting States:
**AT BE BG CH CY CZ DE DK EE ES FI FR GB GR
HR HU IE IS IT LI LT LU LV MC MK MT NL NO PL
PT RO SE SI SK SM TR**

(30) Priority: **18.12.2008 US 138533 P**

(43) Date of publication of application:
**19.10.2011 Bulletin 2011/42**

(73) Proprietor: **Yissum Research Development
Company of the
Hebrew University of Jerusalem, Ltd.
Jerusalem 91390 (IL)**

(72) Inventors:
• **ZIGLER, Arie
75260 Rishon Le Tzion (IL)**
• **EISENMANN, Shmuel
90805 Mevaseret Zion (IL)**
• **PALCHAN, Tala
93115 Jerusalem (IL)**

(74) Representative: **ZBM Patents - Zea, Barlocci &
Markvardsen
Rambla Catalunya, 123
08008 Barcelona (ES)**

(56) References cited:
**US-A1- 2002 090 194**

• **T. PALCHAN ET. AL.: "Generation of fast ions by an efficient coupling of high power laser into snow nanotubes" APPL. PHYS. LETT., vol. 91, no. 25, 18 December 2007 (2007-12-18), pages 251501-1-251501-3, XP002579654 New York**
• **KAHALY ET. AL.: "Near-Complete Absorption of Intense, Ultrashort Laser Light by Sub-Lambda Gratings" PHYS. REV. LETTERS, vol. 101, 145001, 20 October 2008 (2008-10-20), pages 1-4, XP002579655**
• **HUTLEY, MAYSTRE: "The total absorption of light by a diffraction grating" OPTICS COMMUNICATIONS, vol. 19, no. 3, December 1976 (1976-12), pages 431-436, XP002579656 Amsterdam ISSN: 0030-4018**
• **MURNANE ET. AL.: "Efficient coupling of high-intensity subpicosecond laser pulses into solids" APPL. PHYS. LETT., vol. 62, no. 10, 8 March 1993 (1993-03-08), pages 1068-1070, XP002579657 New York**
• **T. PALCHAN ET. AL.: "Efficient coupling of high intensity short laser pulses into snow clusters" APPL. PHYS. LETT., vol. 90, no. 4, 24 January 2007 (2007-01-24), pages 041501-1-041501-3, XP002579658 New York**
• **BAGCHI S ET AL: "Fast ion beams from intense, femtosecond laser irradiated nanostructured surfaces", APPLIED PHYSICS B ; LASERS AND OPTICS, SPRINGER, BERLIN, DE, vol. 88, no. 2, 27 June 2007 (2007-06-27), pages 167-173, XP019540558, ISSN: 1432-0649, DOI: 10.1007/S00340-007-2706-7**

## Description

## FIELD OF THE INVENTION

This invention relates to a system for generating fast ions and a method thereof.

## BACKGROUND OF THE INVENTION

Fast ion beams are of interest for various applications including production of radioactive isotopes, neutron production, radiography, fusion, and various forms of radiation therapy.

Beams of fast ions are typically produced in accelerators of various configurations such as cyclotrons or synchrotrons. Accelerators are relatively large and expensive machines that are costly to run and maintain. The development of lasers that are capable of providing extremely high intensities and electric fields has stimulated research in exposing matter to laser light electric fields to generate fast ions and interest in using lasers to provide relatively inexpensive fast ion sources.

US 6,906,338 describes using laser pulses "having a pulse length between approximately 1 to 500 femtoseconds (fs)" focused to energy densities of between about $10^{18}$ to about $10^{23}$ Watts/cm$^2$ (W/cm$^2$) to produce a high flux of energetic ions such as protons that may be used for medical purposes. The pulses are directed to interact with targets of various designs and provide radiation components that "include different species of ions (e.g., protons), x-rays, electrons, remnants of the pulse 102, and different energy components (e.g., MeV, 10's MeV, and 100's MeV within a certain energy band or window)". The targets may comprise a thin foil layer for absorbing pre-pulse energy of the pulses. A beam transport system allows ions, such as protons, produced in the target and having a predetermined beam emittance and energy to propagate to a "treatment field" for therapeutic applications. The patent describes targets that are concave on a side of the target downstream relative to a propagation direction of the laser pulses and may be formed having grooves, or comprising fibers, clusters, or foams. "The size of grooves, 402, fibers 404, clusters 406 or foams 408 may be designed to be shorter than the size of electron excursion in the pulse field (less than approximately 1 micron)".

US 2002/090194 A1 similarly discloses the generation of fast ions by directing a laser at a randomly nano structured surface.

The Article "Fast ion beams from intense, femtosecond laser irradiated nanostructured surfaces"; by Bagchi et. al, Applied Physics B 88, 167-173 (2007)also discloses this subject-matter and in addition the ion yield from the irradiation of a freshly polished substrate.

## GENERAL DESCRIPTION

An article, "Efficient Coupling of High Intensity Short Laser Pulses into Snow Clusters"; by T. Palchan et al; Applied Physics Letters 90, 041501 (2007); published online 24 January 2007 by some of the same inventors of the present invention, the disclosure of which is incorporated herein by reference, describes coupling intense laser light to a target comprising "elongated snowflakes smaller in diameter than the laser wavelength". The snowflakes are formed on a sapphire (Al$_2$O$_3$) substrate located in a vacuum chamber and cooled to less than -70° C. The inventors found that about 94% of the energy in pulses of laser light of wavelength at 800 nm focused on the snowflakes to intensities between about 1x10$^{15}$ W/cm$^2$ to about 2x10$^{16}$ W/cm$^2$ was absorbed by the snowflakes. The pulses had a pulse width of about 150 fs and a contrast ratio of about 10$^{-3}$.

Another article "Generation of Fast Ions by an Efficient Coupling of High Power Laser Into Snow Nanotubes"; by T. Palchan et al; Applied Physics Letters 91, 251501 (2007); published online 18 December 2007 by some of the same inventors as inventors of the present invention, describes "generation of fast ions during interaction of a short laser pulse at moderate intensity, I ~ 10$^{16}$ - 10$^{17}$ W/cm$^2$, with snow nanotubes". The article, the disclosure of which is incorporated herein by reference, notes that H-like and He-like oxygen having kinetic energy up to 100 keV were generated in the interaction. The target of snow nanotubes "were snow clusters ... grown by depositing H$_2$O vapor into vacuum onto 1 mm thick sapphire (Al$_2$O$_3$) plate at a temperature of 100 K. The snow clusters were randomly deposited to form a layer on the sapphire substrate about 100 microns thick and comprised "elongated cluster with characteristic size in the range of 0.01 - 0.1 $\mu$m".

The inventors have found that for a given intensity of high power coherent electromagnetic radiation, a non-oriented target ($T$) such as described in the articles referenced above, interacting with the radiation beam tends to produce relatively large fluxes of relatively high energy ions.

The inventors have now created oriented patterned targets ($OPT$) and investigated the interaction of such oriented patterned target ($OPT$) with incident electromagnetic radiation. The pattern on a surface of the target substrate has pattern features having certain longitudinal axes (so-called "elongated features") which are uniformly oriented along a certain common axis. Such pattern features of the OPT may be constituted by wire-like elements, e.g. nano-wires, filaments, etc. These oriented pattern features present roughness on the OPT surface, which roughness may or may not be implemented as a continuous-surface relief.

The use of such OPT allows for optimizing parameter(s) of the incident electromagnetic radiation to enhance the efficiency of the radiation coupling into the OPT contributing to creation of fast ions with high kinetic energy. Such optimizable parameters include an angle of incidence of a beam of electromagnetic radiation onto the OPT surface and/or polarization of the incident beam.

As will be described further below, the angle of incidence is a so-called "grazing angle", i.e. angle less than 45° between the beam propagation axis and the OPT surface (or higher than 45° in the meaning of "incident angle" being an angle between the beam propagation axis and the normal to the OPT surface). It should be understood that the optimal value of the grazing angle (magnitude as well as azimuth and elevation) should be appropriately selected and/or gradually varied, in accordance with the critical dimensions of the pattern (including the depth of pits), as well as the direction of orientation, to achieve the generation of an optimal fast ion beam.

As for the polarized electromagnetic radiation e.g. linear polarized light, it should be understood that this means light having a predetermined preferred polarization direction. The polarization direction has been selected relatively to the orientation axis of the *OPT*, and the fluxes and the energy of the ions, seem to be enhanced in comparison with non-oriented targets (*T*). Therefore, using an *OPT* target is more efficient than using T targets for producing relatively fast ions at relatively large fluxes.

It should be understood that, a target comprising randomly oriented filaments is referred to as a "target (*T*)", and that a target having a surface pattern exhibiting a preferred direction of orientation is referred to as an "oriented patterned target (*OPT*)".

In particular, a laser pulse having intensity between about $5 \times 10^{19}$ W/cm$^2$ and about $5 \times 10^{20}$ W/cm$^2$ interacting with an *OPT* target, would produce a burst of protons having energy between about 20 and 200 MeV. The burst may comprise more than $10^6$ protons, more than $10^7$ protons, more than $10^8$ protons, more than $10^9$ protons or even $10^{10}$ protons.

Therefore, the present invention provides a new system according to claim 1.

In some embodiments, the beam unit is adapted to direct the electromagnetic radiation beam onto the patterned surface of the target substrate with a predetermined grazing angle. The grazing angle is selected in accordance with the pattern such that the interaction provides an efficient coupling between the radiation beam and the substrate enabling creation of fast ions of desirably high kinetic energy.

It should be noted that generally, the grazing angle refers to the angle between the beam and the surface, i.e. 90° minus the angle of incidence. In some embodiments, the grazing angle is lesser than 45°. In some embodiments, the grazing angle is in the range of about 20°-40° (i.e. angle of incidence 50° - 70°).

The electromagnetic beam has a pre-defined polarization direction defining a certain angle between the polarization direction and the orientation axis of the pattern features of the target substrate is selected such that the interaction provides an efficient coupling between the radiation beam and the substrate enabling creation of fast ions having a desirably high kinetic energy.

Thus, an angle between a polarization direction of the beam of electromagnetic radiation and the orientation axis of the pattern features of the target substrate, and the grazing angle are selected such that interaction between the radiation beam and the substrate provides an efficient coupling between the radiation beam and the substrate enabling creation of fast ions. By this, the invention enables providing ion sources producing ions in relatively large quantities. In some embodiments, the angle between the polarization direction and the orientation axis is in a range of 0° - 30°.

The system of the present invention provides fast ions having kinetic energy about equal to or greater than at least one of 5 MeV; 50 MeV; 100 MeV; 150 MeV; 200 MeV.

In some embodiments of the invention, the ions comprise protons. In some embodiments of the invention, the ions comprise Oxygen ions.

In some embodiments of the invention, the system comprises a beam unit configured and operable to selectively adjust the direction of polarization to different angles relative to the direction of orientation of the *OPT*.

According to some embodiments of the invention, the radiation beam comprises polarized beam having a desired direction of polarization relative to the direction of orientation of the *OPT*. In some embodiments, the polarization direction is substantially parallel to the orientation axis.

In some embodiments, the beam unit is configured to orient the polarization direction such that the polarization direction is substantially parallel to the direction of orientation.

In other embodiments, the beam unit is configured to orient the polarization direction such that the polarization direction has a relatively small angle (0° - 30°) to the direction of orientation.

In some embodiments of the invention, the beam unit is configured and operable to focus the radiation beam to a spot size in the target for which the beam has a maximum intensity about equal to or greater than at least one of $10^{16}$ W/cm$^2$; $10^{17}$ W/cm$^2$; $10^{18}$ W/cm$^2$; $10^{19}$ W/cm$^2$; $10^{20}$ W/cm$^2$.

In this connection, it should be understood that, an electric field produced by a laser beam with intensity $I \frac{W}{cm^2}$ is $E \approx 27\sqrt{I} \frac{V}{cm}$. For a short powerful laser beam of $10^{12}$ *Watt* focused to a spot diameter of 5 microns, an electric field of about $6 \times 10^{10} \frac{V}{cm}$ is generated at the focal region. This field is larger than the electric field binding the electrons in the Hydrogen atom. Therefore, while interacting, the electrons are photo-ionized through one of three mechanisms. The dominate process would depend on the laser intensity and ionization potential. The first mechanism is a multi-photon ionization mechanism in which a number of photons hit the atom simultaneously to overcome the energetic gap need for ionization (one photon of 800 nm beam has about 1.5 eV). The second mechanism is a tunnel ionization mechanism in which the atom's electric field is distorted by the laser beam and the probability of an electron to tunnel is non negligible due to the reduced potential barrier. The third mechanism is an ionization mechanism over the barrier in which the electric field of the laser beam is large compared to the ionization potential in which the electrons are essentially free and gain kinetic energy from the laser electric field. The Keldysh parameter which is

defined by $\gamma = \sqrt{\dfrac{I_p}{2E_p}}$ , where $I_p$ is the ionization po-

tential and $E_p = 9.33738 \times 10^{-8}\, I[\frac{TW}{cm^2}]\, \lambda[nm]$ is

the ponderomotive potential. When $\gamma \gg 1$ multi-photon ionization is the dominate mechanism for ionization. In the present invention, the radiation beam at the focal point on the target has a maximum intensity about equal to or greater than at least one of $10^{16}$ W/cm$^2$, $10^{17}$ W/cm$^2$, $10^{18}$ W/cm$^2$, $10^{19}$ W/cm$^2$, $10^{20}$ W/cm$^2$, therefore $\gamma < 1$ and the mechanisms involved are the second and in some cases the third mechanism. Therefore, when the leading edge of the radiation beam reaches the target it ionizes the atoms, such that the interaction between the radiation beam and the *OPT* is essentially with plasma.

In some embodiments, the patterned surface of the target substrate is a continuous surface and the pattern comprises grooves.

In some embodiments, the nanoscale features comprises discrete nanostructures which may be elongated.

For example, the nanoscale features have a characteristic width less than or about equal to at least one of $0.5\lambda$; $0.25\lambda$; $0.1\lambda$; $0.05\lambda$; $0.02\lambda$ and a characteristic length greater than or about equal to at least one of $\lambda$; $2\lambda$; $5\lambda$; $10\lambda$.

The inventors believe that the surface pattern of the targets acts as a field concentrator for the electric field of the electromagnetic radiation (e.g. light pulses) interacting with the target.

In particular, according to some embodiments of the invention, the surface pattern comprises a layer of filaments/nanowires characterized by a substantially uniform direction of orientation. In this case, the filaments may act as conductive needles concentrating and amplifying the laser electric field at their ends, like a macroscopic metal needle in an electric field generates an intense electric field at its point, or the local field enhancement measured at plasmon resonances.

In some embodiment of the invention, the surface pattern comprises nano-crescent shaped structures scattered on the substrate all aligned in the same direction. In this case, the nano-cresents can act as bent conducting needles concentrating and amplifying the laser electric field at their ends.

In some embodiments of the invention, the filaments are ice filaments. It should be noted that the terms "ice", "snow", and "H$_2$O vapor" in the context of this patent application are used interchangeably all to refer to pattern features made from water vapor.

In some embodiments of the invention, the patterned surface has a thickness greater than or about equal to at least one of 1 $\mu$m; 10 $\mu$m; 20 $\mu$m; 50 $\mu$m; 100 $\mu$m.

In some embodiments, the target substrate is made of at least one of sapphire, silicon, carbon or plastics material.

In some embodiments, the target substrate is made by interacting the substrate with water vapor in a vacuum chamber while under biasing electric field across the substrate, thereby creating nanoscale features oriented along the electric field.

In some embodiments of the invention, the radiation beam comprises at least one pulse of laser light. Optionally, the pulse has duration less than or about equal to at least one of 1 ps; 0.5 ps; 0.2 ps; 0.1 ps; 0.03 ps.

In some embodiments of the invention, the invention enables a new way of employing "pre-pulses" for plasma production. A pre-pulse is an energy pulse that precedes the main plasma-producing pulse. It should be noted that generally pre-pulses are an artifact of laser amplification and typically have intensities between $10^{-3}$ and $10^{-6}$ that of a laser light pulse that they precede. Pre-pulses generally interfere with interaction of laser light pulses with matter in a target. A pre-pulse typically creates plasma on a surface of a target that reflects energy in the laser light pulse incident on the target surface following the pre-pulse and reduces thereby efficiency with which energy in the following light pulse couples to the target. However, it appears that pre-pulses accompanying laser pulses that interact with an *OPT* target, in accordance with an embodiment of the invention, are dissipated by ablation and ionization of a portion of the targets. The plasma created by a pre-pulse ablating and ionizing a portion of an *OPT* target, in accordance with an embodiment of the invention, is generally sub-critical density plasma, which does not interact strongly with energy in a subsequent pulse associated with, and following, the pre-pulse. As a result, the subsequent pulse is able to interact relatively efficiently with remaining, non-ablated, portions of the targets substantially without interference from plasma generated by the pre-pulse.

Although energy pulses in the form of laser pulses are preferred, other types of energy pulses are also conceivable, such as ultra short electron beam pulses. However, in the following description, energy pulses in the form of laser pulses will be taken as the preferred example. The electromagnetic radiation may be a laser light pulse which typically comprises a pre-pulse preceding the main pulse. However, the system of the present invention may also be used with laser systems reaching very low contrast ratios (i.e. the pre-pulse have intensities between of about $10^{-14}$ of the main pulse). The beam source may be controlled such that the pre-pulse may precede the pulse by a period equal to or greater than about 10 ns. Additionally or alternatively, the surface pattern has a characteristic dimension greater than or about equal to a path length of the beam in the surface pattern sufficient to absorb substantially all the energy in the pre-pulse.

According to another broad aspect of the present invention, there is also provided a method for generating fast ions according to claim 16.

In some embodiments, the method comprises receiving the high power coherent polarized electromagnetic radiation beam and directing the radiation beam onto the surface of the target substrate at a desired grazing angle.

In some embodiments, the method comprises fabricating the target substrate by interacting a substrate with water vapor in a vacuum chamber while under biasing electric field across the substrate, thereby creating a target in the form of patterned substrate, the pattern having nanoscale features oriented in a predetermined substantially homogeneous direction along the electric field.

**BRIEF DESCRIPTION OF THE DRAWINGS**

In order to understand the invention and to see how it may be carried out in practice, embodiments will now be described, by way of non-limiting example only, with reference to the accompanying drawings, in which:

Figs. 1A-1B schematically shows a general block diagram of the system for generating fast ions and of a method thereof, in accordance with an embodiment of the invention;
Fig. 2 graphically shows the interaction of different targets with the same radiation beam;
Figs. 3A-3C shows the interaction of targets with a radiation beam at different grazing angles;
Fig. 4 schematically shows an example of the system for generating fast ions, in accordance with an embodiment of the invention;
Fig. 5 schematically shows another example of the system for generating fast ions, in accordance with another embodiment of the invention;
Figs. 6A-6C schematically illustrate interaction of a polarized radiation beam with the target shown in Fig. 3, in accordance with an embodiment of the invention;
Fig. 7 schematically shows another configuration of a system for generating fast ions in accordance with an embodiment of the invention.

**DETAILED DESCRIPTION OF EMBODIMENTS**

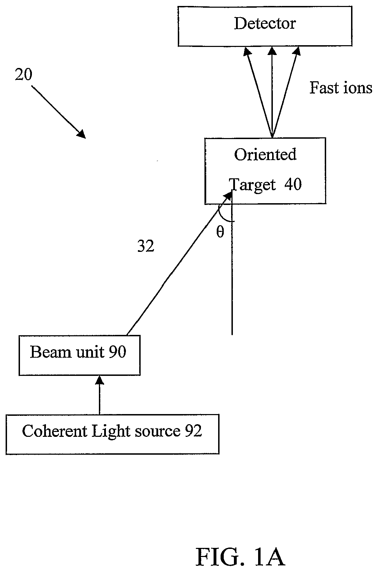

Fig. 1A schematically shows a block diagram system for generating a beam of fast ions 20 comprising an oriented patterned target (OPT) 40 interacting with an electromagnetic radiation 32, in accordance with an embodiment of the invention. The OPT substrate 40 has a surface pattern with sub-resonant nanoscale features oriented substantially homogeneous along a certain axis indicated by 44 (i.e. having a predetermined substantially homogeneous direction of orientation). The system 20 comprises a beam unit 90 to be used with a high power coherent electromagnetic radiation source 92 configured and operable to receive a high power coherent electromagnetic radiation beam and to direct a radiation beam having a predetermined polarization direction onto the surface of the target substrate at a desired grazing angle $\theta$. An angle between a polarization direction of the beam of electromagnetic radiation and the orientation axis of the pattern features of the target substrate, and the grazing angle are selected such that interaction between the radiation beam and the substrate provides an efficient coupling between the radiation beam and the substrate enabling creation of fast ions. In particular, the polarization direction of the radiation beam is selected to be have a predetermined orientation with respect to the orientation axis of the substrate such that interaction between the radiation beam 32 and the substrate 40 provides an efficient coupling between the radiation beam and the substrate enabling creation of fast ions. The fast ion energy may be measured by a detector by means of line profile measurements of the x-ray radiated by the created plasma (e.g. through x-ray emission spectra of multicharged ions of Oxygen). The detector may be a high luminosity, spherical FSSR spectrometer with a bent mica crystal (curvature radius R=150 mm) measuring soft x-ray spectra in the wavelength range 1.85 - 1.90 nm. The x-ray spectra may be recorded by an Andor back illuminated x-ray CCD with various exposure time for each experiment.

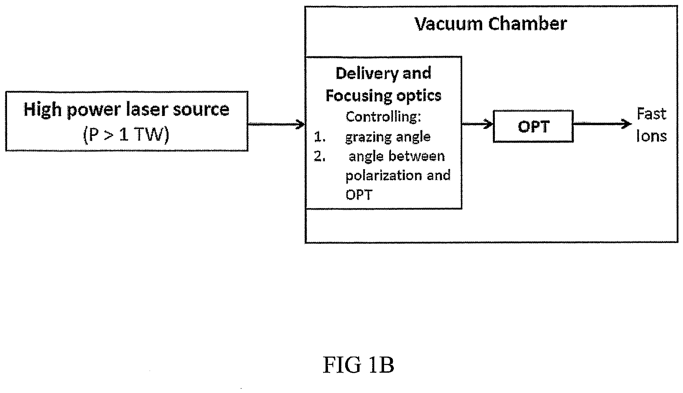

Fig. 1B illustrates a flow chart of the process used according to the teachings of the present invention. The method for generating fast ions comprises irradiating an OPT with a high power polarized coherent electromagnetic radiation beam (e.g. high power laser source having a power of at least 1 TW) and optimizing a relation between the pattern of the OPT and at least one parameter of the electromagnetic radiation by selecting/controlling at least one of an angle between a polarization direction of the beam of electromagnetic radiation and the orientation axis of the OPT, and an incident angle (i.e. grazing angle) for the beam of electromagnetic radiation, such that interaction between the radiation beam and the patterned surface of the OPT provides an efficient coupling between the radiation beam and the substrate resulting in generation of a fast ions' beam.

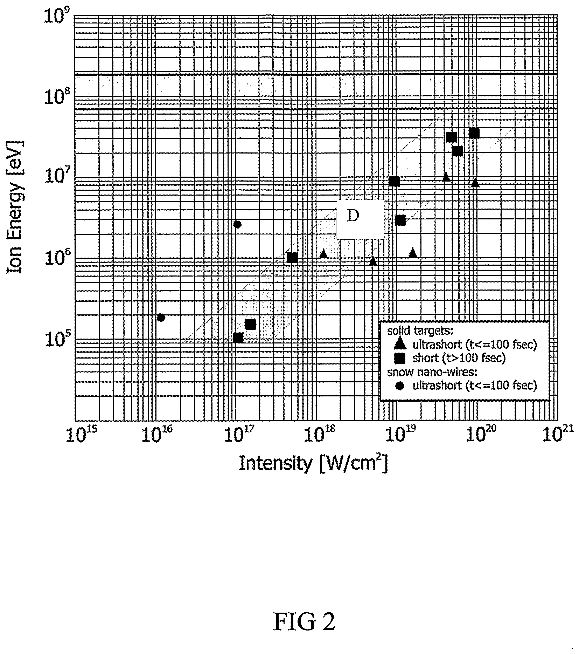

Fig. 2 graphically represents the interaction between a radiation beam and three different laser-targets schemes, wherein the square and triangle marks are ions generated from solid target irradiated by short (>100 fsec) and ultrashort (<100 fsec) laser pulses respectively and filled circles are ions from an ultrashort laser and an OPT target.

Region D of the figure represents the common knowledge in the field using various laser configurations. The proton energy is approximately scaled as the square root of the laser intensity (i.e. $E_{protons} \sim I^{0.6}$). As clearly seen in the figure, *OPT* target (filled circles) provides about an order of magnitude above the results obtained by the other targets (square and triangle marks).

In a specific and non-limiting example, the *OPT* target is formed by $H_2O$ nano-wires layed on a substrate of sapphire. The diameter of the wires is about 100 nm while their length is a few micrometers. The wires are therefore sub-resonant, e.g. the diameter of the wires is smaller than the irradiated laser electric field wavelength which is about 0.8 $\mu$m. The inventors have found that, when exposed, the target absorbs over 95% of incident light. Moreover, as detailed below, the target is less susceptible to the pre-pulse, which typically reduce the coupling of radiation beam to target. The target also enhances the electric field associated with the interaction and acceleration of charged particles.

In some embodiments, the surface pattern of the targets acts as a field concentrator for the electric field of the electromagnetic radiation (e.g. light pulses) interacting with the target. In particular, according to some embodiments of the invention, the surface pattern comprises a layer of filaments/wires characterized by a direction of orientation. In this case, the filaments may act as conductive needles concentrating and amplifying the laser electric field at their ends, like a macroscopic metal needle in an electric field generates an intense electric field at its point. The geometrical dimensions of the narrow tips at the end of the wires generate a large charge-separation when irradiated by the electric field. As mentioned above, the high intensity laser pulse ionizes the wires. The charge separation induced by the wire geometry is locally added to the electric field of the laser interacting with the individual particles (electron and protons).

The main parameter for calculating the field enhancement is the geometrical ratio, g, which is the ratio between the diameter and length of a nanoscale feature.

The field enhancement factor (*FEF*) scales with

g linearly, $FEF = \dfrac{E_{enhanced}}{E_{laser}} \propto g$ . Here $E_{laser}$ is the

corresponding electric field to irradiated laser pulse and $E_{enhanced}$ is the effective electric field that is involved in the acceleration process of the ions.

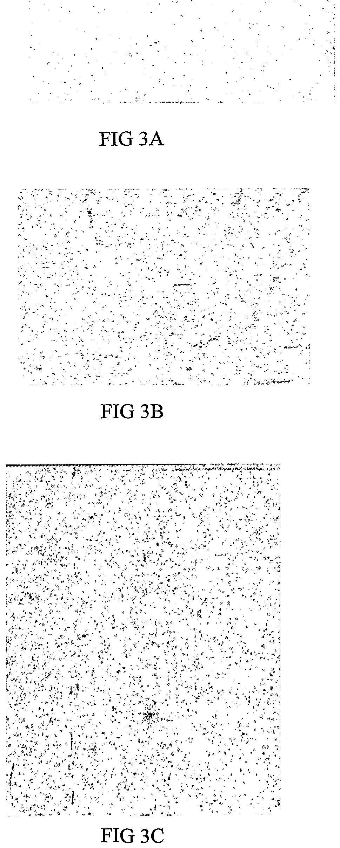

Reference is made to **Figs. 3A-3C** illustrating protons generated by from the interaction of an *OPT* with incident electromagnetic beam at different angles of incidence. In this specific and non-limiting example, the ions energies are measured by CR39 plates covered with aluminum sheets blocking protons below certain energy. The black dots represent ion marks in the CR39. **Fig. 3A** represents the background level of the system for reference purpose. **Fig. 3B** represents the interaction between the target and an incident beam hitting the patterned surface with an incident angle of 45°. The protons energy cut-off is 0.5 MeV. The solid angle of the ions beam covered by the-CR39 plates is about 34° (perpendicular to the target). **Fig. 3C** represents the interaction between the target and an incident beam hitting the patterned surface with an incident angle of 60° (i.e. grazing angle of 30°). The protons energy cut-off is 5 MeV. The solid angle covered by the CR39 plates is about 5° (perpendicular to the target). Therefore, it is clearly shown that the use of the *OPT* allows for optimizing parameter(s) of the incident electromagnetic radiation, incident angle in the present example, to enhance the efficiency of the radiation coupling into the *OPT* (e.g. energy cut-off and solid angle) contributing to creation of fast ions with high kinetic energy. The figures illustrate the optimization of the variation of the grazing angle of the electromagnetic beam onto the *OPT* surface. The incident angle should therefore be higher than 45° (small grazing angle) being an angle between the beam propagation axis and the normal to the *OPT* surface. In this specific example, the irradiation of the *OPT* at a grazing angle of about 60° generates a quantity of fast ions (e.g. protons) by at least a factor of 36. The fast ions beam has kinetic energy higher by at least a factor of 10. According to the teachings of the present invention, the optimal angle may be determined by appropriately varying gradually the grazing angle and measuring the properties of the generated fast ions beams. It should be understood that the actual value of the grazing angle depends *inter alia* on the pattern features e.g. the height of the grooves.

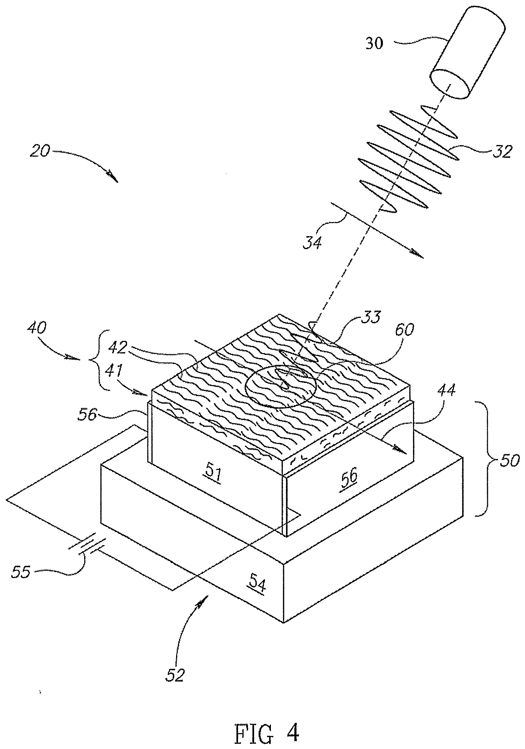

**Fig. 4** schematically shows an example of a system for generating fast ions **20** comprising an oriented patterned target (*OPT*) **40** interacting with an electromagnetic radiation, in accordance with an embodiment of the invention.

The radiation beam **32** is directed towards to target **40** at a desired grazing angle $\theta$. The radiation beam **32** has a predetermined polarization direction indicated by an arrow **34**. For example, the beam unit **30** is controllable to provide polarized laser beam pulses that are focused to a focal region in *OPT* **40** schematically indicated by a circle **60**.

In this specific and non-limiting example, the surface pattern of the *OPT* **40** comprises oriented filaments formed on and supported by a target pedestal **50**. An arrow **44** indicates a direction of orientation that characterizes orientation of nanoscale features 42 and *OPT* **40**. In an embodiment of the invention, polarization direction **34** is substantially parallel to direction **44** of orientation of *OPT* **40**.

Pedestal **50** may comprise a sapphire substrate **51** coupled to a cooling unit **52** configured in accordance with any of various techniques known in the art. Optionally, cooling unit **52** comprises a Cu heat exchanger block **54** coupled to a liquid nitrogen circulation system (not shown) that pumps liquid nitrogen through the heat exchanger to remove heat from sapphire substrate **51**. The substrate is sandwiched between bias electrodes **56** that are connected to a power supply **55**. *OPT* **40** and pedestal **50** are located in a vacuum chamber (not shown).

To produce *OPT* **40,** in accordance with an embodiment of the invention, pressure in the vacuum chamber is reduced to between about $5 \times 10^{-4}$ mBar to about $10^{-5}$ mBar and the cooling unit is operated to cool substrate **51** to about 80° K. Power supply **55** is controlled to apply a potential voltage between electrodes **56** that generates a biasing electric field in substrate **51,** which is parallel to direction of orientation **44.** Water vapor is then introduced into the vacuum chamber and condenses on substrate **51** in the form of elongated ice filaments **42.** Because water is a polar molecule, as the molecules condense onto the substrate and grow ice filaments **42,** the molecules, and the ice filaments tend to orient parallel to the electric biasing field and thereby direction of orientation **44.** Other materials having the ability to be patterned, the pattern having nanoscale pattern features oriented substantially uniformly along a common axis, such as silicon, carbon or plastics (i.e. C-H composites) can also be used to form the target substrate having a substantially uniform direction of orientation according to the teachings of the present invention.

In some embodiments, the radiation beam **32** includes a beam pulse.

In an embodiment of the invention, water vapor is introduced into the vacuum chamber for a period long enough to grow layer **41** of surface pattern to thickness sufficient to absorb substantially all the energy in pre-pulse **33** and pulse **32.** Pre-pulse **33** energy would therefore be dissipated by ablating and ionizing a portion of layer **41** and leave in place of the ablated material a relatively thin, sub-critical density, plasma overlaying a remaining portion of layer **41** prior to pulse **32** reaching the layer. The sub-critical density plasma does not interact strongly with energy in pulse **32,** and as a result, energy in pulse **32** couples efficiently to the nanoscale features **42** in the remaining non-ablated portion of layer **41.**

The presence of the electric field generated in substrate **51** would of course not result in all nanoscale features **42** that condense on the substrate being substantially aligned along direction **44.** However, the electric field results in a density of aligned surface pattern (e.g. ice filaments) that characterizes layer **41** and *OPT* **40** with orientation direction **44.** And it is expected that interaction of *OPT* **40** with pulse **33** of beam polarized in a direction, *e.g.* direction **34,** parallel to direction of target orientation **44,** in accordance with an embodiment of the invention, would be enhanced relative to interaction of the pulse with a non-oriented target T. Ion fluxes and energies provided by interaction of radiation beam (e.g. laser light pulse) with *OPT* **40** are therefore expected to be enhanced relative fluxes and energies provided by interaction of the light pulse with a T target.

The inventors have conducted experiments with a T target comprising a layer of non-oriented ice filaments interacting with intense, 800 nm wavelength laser light pulses to produce fast ions. An experiment conducted by the inventors was reported in the article entitled "Generation of Fast Ions by an Efficient Coupling of High Power Laser into Ice Nanotubes", referenced above. The experiments indicate that fluxes of 150 KeV protons are produced per laser light pulse having pulse width less than about 0.1 ps and "moderate" intensity of about $10^{16}$ W/cm$^2$ incident on a 1 mm thick T ice filament target formed on a target pedestal similar to pedestal **50.** To produce same energy protons from conventional interaction of a laser light pulse and a solid, non-filamentary target, the laser pulse typically requires intensity of about $10^{17}$ W/cm$^2$, which is about an order of magnitude greater than that required using a T target.

In some embodiments of the invention, beam unit **30** focuses beam radiation **32** (e.g. laser light pulse) to a maximum intensity about equal to or greater than at least one of the followings: $10^{16}$ W/cm$^2$; $10^{17}$ W/cm$^2$; $10^{18}$ W/cm$^2$; $10^{19}$ W/cm$^2$; $10^{20}$ W/cm$^2$.

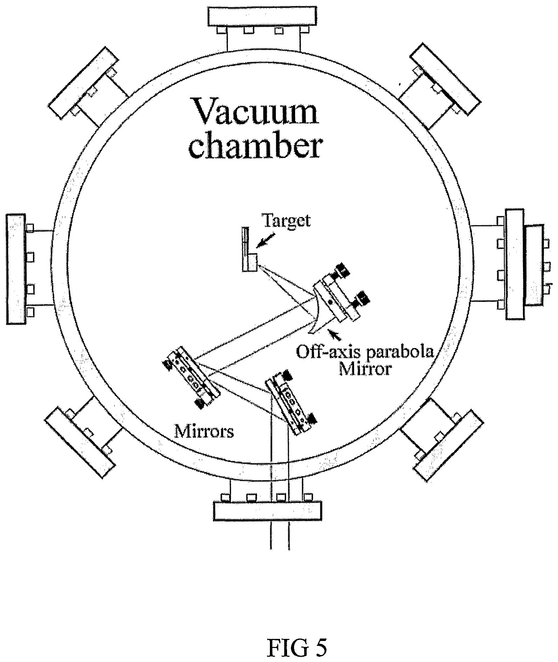

Fig. 5 illustrates a configuration of an example of the system of the present invention in which, the beam unit comprise an arrangement of dielectric mirrors and of an off-axis parabola mirror (e.g. gold coated) configured and operable to focus the radiation beam to a focal region.

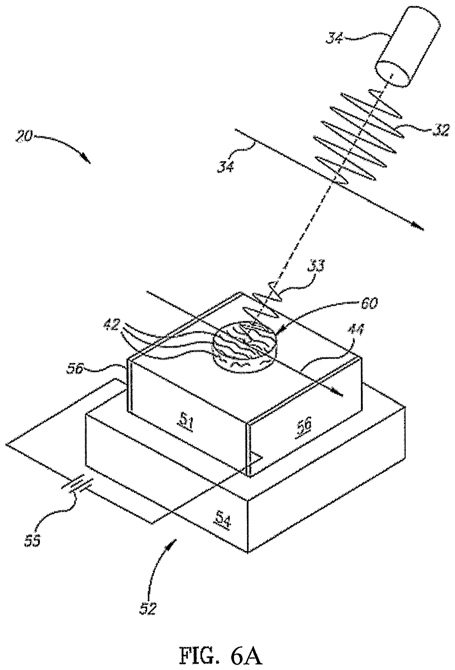

Figs. 6A-6C schematically illustrate a process of generating fast protons, in accordance with an embodiment of the invention. In this specific and non-limiting example, fast protons having an energy of about 50 MeV are produced by the system **20** of the present invention in which a radiation beam **32** (e.g. laser light pulse) is assumed to have a wavelength of 800 nm, pulse width of about 0.1 ps, and an intensity of about $5 \times 10^{19}$ W/cm$^2$ in a focal plane (when focused to focal region **60** of target *OPT* **40**). Assuming a contrast ratio (ratio of pre-pulse intensity to main pulse intensity) of maximum $10^{-3}$, when focused to focal region **60,** pre-pulse **33** has intensity equal to maximum $10^{16}$ W/cm$^2$. It should thus be understood that the energy of the pre-pulse and the position of the focal plane should be appropriately adjusted to on the one hand provide interaction at the desired energy of the beam for efficient coupling and on the other hand the focal plane energy should not be too high to not destroy the pattern features.

Fig. 6A schematically shows the system **20** of the present invention just before the interaction between the radiation beam and the *OPT* **20.**

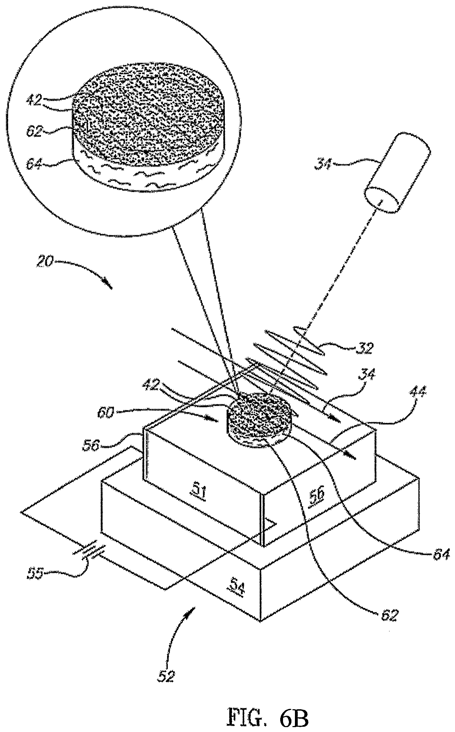

Fig. 6B schematically shows the system **20** of the present invention after pre-pulse **33** has ablated and ionized, and has created a "burn off' layer having patterned nanoscale features **42** in focal region **60,** leaving a sub-critical density plasma, represented by a shaded region **62.** Plasma **62** overlays a remaining, non-ablated region **64** of nanoscale features **42** in focal region **60.** In the figure, laser pulse **32** is just entering focal region **60.** Because plasma **62** is sub-critical it does not substantially affect laser pulse **32.**

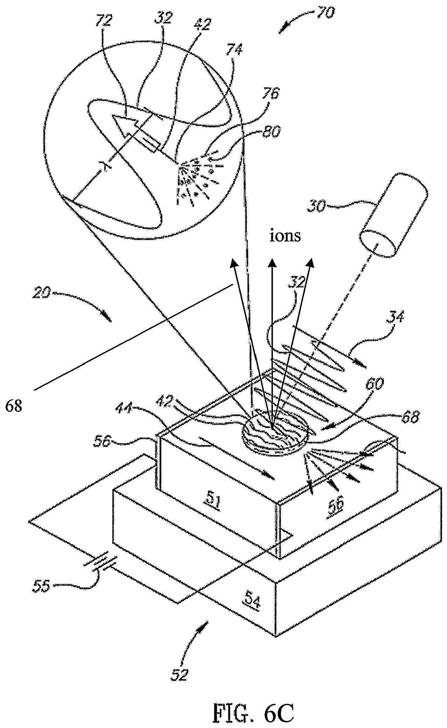

Fig. 6C schematically shows laser pulse **32** interacting with nanoscale features **42** in non-ablated region **64** to produce a flux of protons schematically represented by a cluster of dot-dash arrows **68,** in accordance with an embodiment of the invention.

Because the surface pattern has sub-resonant nanoscale features **42** e.g. the width of the surface pattern is much smaller than the wavelength of light in pulse **32,** the electric field of the pulse at any given moment is substantially constant within and in the neighborhood of the surface pattern. Without being bound by any particular theory, as mentioned before, the inventors believe that the surface pattern therefore acts similarly to a conducting needle in, and parallel to, an electric field, and concentrates the field at its tips, and that the concentrated field of a plurality of oriented nanoscale features **42** is particularly advantageous for generating a relatively large flux of fast protons. An inset **70** schematically shows nanoscale features **42** in the electric field of a localized region of pulse **32** smaller than a wavelength λ of light in the pulse. A block arrow **72** represents the electric field of light pulse **32** near feature **42** and dashed field lines **76** converging towards a tip **74** of the feature schematically represent the concentrated field at the tip.

Concentrated field **76** generates a plume of hot electrons, schematically represented by circles **80,** that leave feature **42** near its tip **74** by ionizing hydrogen and oxygen atoms (not shown) in the feature. The plume of electrons and ionized atoms in feature **42** produce an intense double layer field (not shown) that accelerates hydrogen ions in the filament to relatively high energies producing the flux of protons represented by cluster of arrows **68.**

It is noted that efficacy with which light pulse **32** produces fast ions **68** by interacting with *OPT* **40** (**Fig. 3**) is responsive to direction **34** of polarization of light in pulse **32** relative to direction **44** of nanoscale feature orientation in *OPT* **40.** For example, as described above, the light pulse is particularly effective in producing a flux of fast ions, such as protons, when direction **34** and direction **44** of feature orientation are parallel or having a small angle between them. In some embodiments of the invention, magnitude and/or energy of ions produced by the system of the invention **20** is controlled by controlling the angle of polarization direction **34** relative to direction of feature orientation. By rotating polarization **34** away from the correct angle between polarization **34** and direction **44** of filament orientation, energy of protons is expected to decrease. Thus, an angle between the polarization direction and the orientation axis of the pattern can be appropriately adjusted to optimal value.

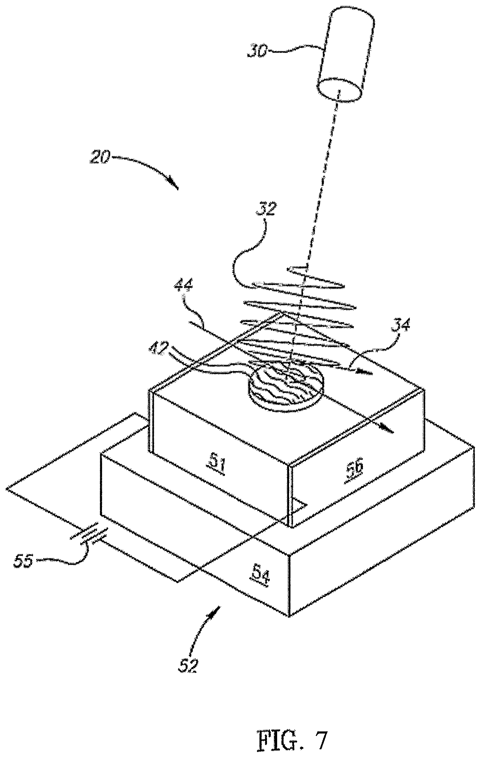

**Fig. 7** schematically shows polarization of pulse **32** rotated, in accordance with an embodiment of the invention, away from direction **44** of features orientation.

**Claims**

**1.** A system for generating a beam of fast ions, the system comprising:

a target substrate (40) having a patterned surface, a pattern comprising nanoscale pattern features (42) oriented substantially uniformly along a common axis;

a beam unit (30) adapted for receiving a high power coherent electromagnetic radiation beam (32) and providing an electromagnetic radiation beam (32) having a main pulse and a pre-pulse, and focusing said radiation beam onto said patterned surface of the target substrate (40) to cause interaction between said radiation beam (32) and said substrate (40), such that the pre-pulse ablates and ionizes a portion of the substrate (40) creating low density plasma enabling the subsequent main pulse to interact efficiently with remaining, non-ablated, portions of the substrate (40), thereby enabling creation of fast ions from the interaction between the main pulse and the target substrate; and **characterized in that**: said electromagnetic beam has a pre-defined polarization direction defining a certain angle between said polarization direction and said common orientation axis (44) of the pattern features (42) of the target substrate (40) selected such that said interaction provides an efficient coupling between said radiation beam and said substrate enabling creation of fast ions having a desirably high kinetic energy., wherein said angle between the polarization direction and the orientation axis is in a range of 0° - 30°.

**2.** The system of claim 1, wherein said beam unit (30) is adapted to direct the electromagnetic radiation beam (32) onto said patterned surface of the target substrate (40) with a predetermined grazing angle; the grazing angle being selected in accordance with said pattern such that said interaction provides an efficient coupling between said radiation beam and said substrate enabling creation of fast ions of desirably high kinetic energy.

**3.** The system of claim 2, wherein said grazing angle is less than 45°.

**4.** The system of claim 3, wherein said grazing angle is in the range of about 20° - 40°.

**5.** The system of claim 1, wherein said polarization direction is substantially parallel to the orientation axis (44).

**6.** The system of any one of claims 1 to 5, wherein said patterned surface of the target substrate (40) is a continuous surface and said pattern comprises grooves.

**7.** The system of any one of claims 1 to 5, wherein said features (42) comprises discrete structures.

**8.** The system of claim 7, wherein said structures are elongated.

**9.** The system of claim 8, wherein said structures are filaments or wires.

**10.** The system of claim 9, wherein said filaments are ice filaments.

**11.** The system of any one of claims 1 to 9, wherein said target substrate (40) is made of at least one of sapphire, silicon, carbon or plastics material.

**12.** The system of any one of claims 1 to 11, wherein said beam unit is configured and operable to focus the radiation beam (32) to a spot size in the target for which the radiation beam (32) has a maximum intensity about equal to or greater than at least one of $10^{16}$ W/cm$^2$, $10^{17}$ W/cm$^2$, $10^{18}$ W/cm$^2$, $10^{19}$ W/cm$^2$, $10^{20}$ W/cm$^2$.

**13.** The system of any one of claims 1 to 12, wherein said fast ions have kinetic energy about equal to or greater than at least one of 5 MeV, 50 MeV, 100 MeV, 150 MeV, 200 MeV.

**14.** The system of any one of claims 1 to 13, wherein said fast ions comprise protons.

**15.** The system of any one of claims 1 to 14, wherein said fast ions comprise Oxygen ions.

**16.** A method for generating fast ions, the method comprising irradiating a target substrate (40) with a focused high power polarized coherent electromagnetic radiation beam (32), wherein the target substrate (40) has a patterned surface with a pattern comprising nanoscale pattern features (42) oriented substantially uniformly along a common orientation axis; (44) and wherein said irradiating comprises producing said radiation beam (32) having a main pulse and a pre-pulse, and controlling the angle between a polarization direction of the beam of electromagnetic radiation and the orientation axis (44) in a range of 0° - 30°, such that the pre-pulse ablates and ionizes a portion of the substrate (40) creating low density plasma enabling the subsequent main pulse to interact efficiently with remaining, non-ablated, portions of the substrate, thereby providing an efficient coupling between said radiation beam (32) and said substrate resulting in generation of a fast ions' beam.

**17.** The method of claim 16, comprising receiving the high power coherent polarized electromagnetic radiation beam (32) and directing said radiation beam (32) onto said surface of said target substrate (40) at a desired grazing angle.

**18.** The method of Claim 17, wherein said grazing angle is less than 45° between a beam propagation axis and a surface of the substrate (40), such that said interaction between said radiation beam (32) and said substrate (40) enables creation of the fast ions of desirably high kinetic energy.

**Patentansprüche**

**1.** Ein System zur Erzeugung von einem Strahl von schnellen Ionen, wobei das System folgendes umfasst:

ein Zielsubstrat (40), das eine gemusterte Oberfläche hat, wobei ein Muster nanoskalige Mustermerkmale (42) umfasst, die im Wesentlichen gleichmäßig entlang einer gemeinsamen Achse ausgerichtet sind,
eine Strahleinheit (30), die angepasst ist zum Empfang von einem kohärenten elektromagnetischen Hochleistungsstrahlungsstrahl (32) und zur Bereitstellung von einem elektromagnetischen Strahlungsstrahl (32), der einen Hauptimpuls und einen Vorimpuls hat, und zur Fokussierung des Strahlungsstrahls auf die gemusterte Oberfläche des Zielsubstrats (40), um eine Interaktion zwischen dem Strahlungsstrahl (32) und dem Substrat (40) herbeizuführen, so dass der Vorimpuls einen Teil des Substrats (40) abträgt und ionisiert, wodurch Plasma niedriger Dichte entsteht, was eine effiziente Interaktion des darauffolgenden Hauptimpulses mit verbleibenden, nicht abgetragenen Teilen des Substrats (40) ermöglicht, wodurch die Erzeugung von schnellen Ionen aus der Interaktion zwischen dem Hauptimpuls und dem Zielsubstrat ermöglicht wird; und **dadurch gekennzeichnet, dass**
der elektromagnetische Strahl eine vordefinierte Polarisierungsrichtung aufweist, welche einen bestimmten Winkel zwischen der Polarisierungsrichtung und der gemeinsamen Ausrichtungsachse (44) der Mustermerkmale (42) des Zielsubstrats (40) definiert, der so ausgewählt ist, dass die Interaktion eine effiziente Kopplung zwischen dem Strahlungsstrahl und dem Substrat bietet, was die Erzeugung von schnellen Ionen mit einer gewünschten hohen kinetischen Energie ermöglicht, wobei der Winkel zwischen der Polarisierungsrichtung und der Ausrichtungsachse im Bereich von 0° - 30° liegt.

**2.** Das System des Anspruchs 1, wobei die Strahleinheit (30) angepasst ist, um den elektromagnetischen Strahlungsstrahl (32) auf die gemusterte Oberfläche des Zielsubstrats (40) mit einem vorbestimmten Glanzwinkel zu richten; wobei der Glanzwinkel entsprechend dem Muster ausgewählt wird, so dass die Interaktion eine effiziente Kopplung zwischen dem Strahlungsstrahl und dem Substrat bietet, wodurch die Erzeugung von schnellen Ionen einer gewünschten hohen kinetischen Energie ermöglicht wird.

3. Das System des Anspruchs 2, wobei der Glanzwinkel weniger als 45° beträgt.

4. Das System des Anspruchs 3, wobei der Glanzwinkel im Bereich von ca. 20° - 40° liegt.

5. Das System des Anspruchs 1, wobei die Polarisierungsrichtung im Wesentlichen parallel zur Ausrichtungsachse (44) ist.

6. Das System von einem der Ansprüche 1 bis 5, wobei die gemusterte Oberfläche des Zielsubstrats (40) eine durchgehende Fläche ist und das Muster Nuten umfasst.

7. Das System von einem der Ansprüche 1 bis 5, wobei die Merkmale (42) diskrete Strukturen umfasst.

8. Das System des Anspruchs 7, wobei die Strukturen länglich sind.

9. Das System des Anspruchs 8, wobei die Strukturen Fäden oder Drähte sind.

10. Das System des Anspruchs 9, wobei die Fäden Eisfäden sind.

11. Das System von einem der Ansprüche 1 bis 9, wobei das Zielsubstrat (40) aus mindestens einem von Saphir, Silizium, Kohlenstoff oder einem Kunststoffmaterial besteht.

12. Das System von einem der Ansprüche 1 bis 11, wobei die Strahleinheit konfiguriert ist und betrieben werden kann, um den Strahlungsstrahl (32) auf eine Spotgröße im Ziel zu fokussieren, für das der Strahlungsstrahl (32) eine Höchstintensität aufweist, die etwa gleich oder höher als mindestens eine von $10^{16}$ W/cm$^2$, $10^{17}$ W/cm$^2$, $10^{18}$ W/cm$^2$, $10^{19}$ W/cm$^2$, $10^{20}$ W/cm$^2$ ist.

13. Das System von einem der Ansprüche 1 bis 12, wobei die schnellen Ionen eine kinetische Energie haben, die etwa gleich oder größer als mindestens eine von 5 MeV, 50 MeV, 100 MeV, 150 MeV, 200 MeV ist.

14. Das System von einem der Ansprüche 1 bis 13, wobei die schnellen Ionen Protonen umfassen.

15. Das System von einem der Ansprüche 1 bis 14, wobei die schnellen Ionen Sauerstoffionen umfassen.

16. Ein Verfahren zur Erzeugung von schnellen Ionen, wobei das Verfahren folgendes umfasst:

das Bestrahlen von einem Zielsubstrat (40) mit einem fokussierten polarisierten kohärenten elektromagnetischen Hochleistungsstrahlungsstrahl (32), wobei das Zielsubstrat (40) eine gemusterte Oberfläche mit einem Muster hat, das nanoskalige Mustermerkmale (42) umfasst, die im Wesentlichen gleichmäßig entlang einer gemeinsamen Ausrichtungsachse (44) ausgerichtet sind; und
wobei das Bestrahlen das Erzeugen vom Strahlungsstrahl (32) umfasst, der einen Hauptimpuls und einen Vorimpuls hat, und das Regeln des Winkels zwischen einer Polarisationsrichtung des Strahls elektromagnetischer Strahlung und der Ausrichtungsachse (44) in einem Bereich von 0° - 30° umfasst, so dass der Vorimpuls einen Teil des Substrats (40) abträgt und ionisiert, wodurch Plasma niedriger Dichte erzeugt wird, wodurch eine effiziente Interaktion des darauffolgenden Hauptimpulses mit verbleibenden, nicht abgetragenen Teilen des Substrats ermöglicht wird, wodurch eine effiziente Kopplung zwischen dem Strahlungsstrahl (32) und dem Substrat bereitgestellt wird, was die Erzeugung von einem Strahl schneller Ionen zur Folge hat.

17. Das Verfahren des Anspruchs 16, umfassend das Empfangen des kohärenten polarisierten elektromagnetischen Hochleistungsstrahlungsstrahl (32) und das Ausrichten des Strahlungsstrahls (32) auf die Oberfläche des Zielsubstrats (40) mit einem gewünschten Glanzwinkel.

18. Das Verfahren des Anspruchs 17, wobei der Glanzwinkel zwischen einer Strahlausbreitungsachse und einer Fläche des Substrats (40) weniger als 45° beträgt, so dass die Interaktion zwischen dem Strahlungsstrahl (32) und dem Substrat (40) die Erzeugung von den schnellen Ionen einer gewünschten hohen kinetischen Energie ermöglicht.

**Revendications**

1. Un système de génération d'un faisceau d'ions rapides, le système comprenant :

un substrat cible (40) ayant une surface à motifs, un motif comprenant des caractéristiques de motif de nano-échelle (42) orientées essentiellement uniformément le long d'un axe commun, une unité de faisceau (30) adaptée pour recevoir un faisceau de rayonnement (32) électromagnétique cohérent à haute puissance et fournir un faisceau de rayonnement (32) électromagnétique ayant une impulsion principale et une pré-impulsion, et focaliser ledit faisceau de rayonnement sur ladite surface à motifs du substrat cible (40) afin d'entraîner l'interaction entre ledit faisceau de rayonnement (32) et ledit substrat (40), de façon que la pré-impulsion ablate et ionise une partie du substrat (40) créant un plasma basse densité permettant l'interaction de l'impulsion principale postérieure de manière efficiente avec des parties restantes, non ablatées du substrat (40), permettant ainsi la création d'ions rapides à partir de l'interaction entre l'impulsion principale et le substrat cible ; et **caractérisé en ce que** :

ledit faisceau électromagnétique a une direction de polarisation prédéfinie définissant un certain angle entre ladite direction de polarisation et ledit axe d'orientation (44) commun des caractéristiques de motifs (42) du substrat cible (40) choisi de façon que ladite interaction fournit un couplage efficient entre ledit faisceau de rayonnement et ledit substrat permettant la création d'ions rapides ayant une énergie cinétique souhaitablement haute, dans lequel ledit angle entre la direction de polarisation et l'axe d'orientation est dans l'intervalle de 0° - 30°.

2. Le système de la revendication 1, dans lequel ladite unité de faisceau (30) est adaptée pour diriger le faisceau de rayonnement (32) électromagnétique sur ladite surface à motifs du substrat cible (40) avec un angle de brillance prédéterminé ; l'angle de brillance étant choisi conformément audit motif de sorte que ladite interaction fournit un couplage efficient entre ledit faisceau de rayonnement et ledit substrat permettant la création d'ions rapides ayant une énergie cinétique souhaitablement haute.

3. Le système de la revendication 2, dans lequel ledit angle de brillance est inférieur à 45°.

4. Le système de la revendication 3, dans lequel ledit angle de brillance est dans l'intervalle d'environ 20° - 40°.

5. Le système de la revendication 1, dans lequel la direction de polarisation est essentiellement parallèle à l'axe d'orientation (44).

6. Le système de l'une quelconque des revendications 1 à 5, dans lequel ladite surface à motifs du substrat cible (40) est une surface continue et ledit motif comprend des rainures.

7. Le système de l'une quelconque des revendications 1 à 5, dans lequel lesdites caractéristiques (42) comprennent des structures discrètes.

8. Le système de la revendication 7, dans lequel lesdites structures sont allongées.

9. Le système de la revendication 8, dans lequel lesdites structures sont des filaments ou des fils.

10. Le système de la revendication 9, dans lequel lesdites filaments sont des filaments de gel.

11. Le système de l'une quelconque des revendications 1 à 9, dans lequel ledit substrat cible (40) est fait en au moins un parmi le saphir, le silicium, le carbone ou un matériau plastique.

12. Le système de l'une quelconque des revendications 1 à 11, dans lequel ladite unité de faisceau est configurée et peut fonctionner pour focaliser le faisceau de rayonnement (32) sur une taille de spot dans la cible pour laquelle le faisceau de rayonnement (32) a une intensité maximale à peu près égale ou supérieure à au moins une parmi $10^{16}$ W/cm$^2$, $10^{17}$ W/cm$^2$, $10^{18}$ W/cm$^2$, $10^{19}$ W/cm$^2$, $10^{20}$ W/cm$^2$.

13. Le système de l'une quelconque des revendications 1 à 12, dans lequel lesdits ions rapides ont une énergie cinétique à peu près égale ou supérieure à au moins une parmi 5 MeV, 50 MeV, 100 MeV, 150 MeV, 200 MeV.

14. Le système de l'une quelconque des revendications 1 à 13, dans lequel lesdites ions rapides comprennent des protons.

15. Le système de l'une quelconque des revendications 1 à 14, dans lequel lesdites ions rapides comprennent des ions d'oxygène.

16. Un procédé pour générer des ions rapides, le procédé comprenant irradier un substrat cible (40) avec un faisceau de rayonnement (32) électromagnétique cohérent polarisé à haute puissance focalisé, dans lequel le substrat cible (40) a une surface à motifs avec un motif comprenant des caractéristiques de motif de nano-échelle (42) orientées essentiellement uniformément le long d'un axe d'orientation (44) commun ; et

dans lequel ladite irradiation comprend produire ledit faisceau de rayonnement (32) ayant une impulsion principale et une pré-impulsion, et contrôler ledit angle entre une direction de polarisation du faisceau de rayonnement électromagnétique et l'axe d'orientation (44) dans un intervalle de 0° - 30°, de façon que la pré-impulsion ablate et ionise une partie du substrat (40) créant du plasma basse densité permettant que l'impulsion principale postérieure interagisse de manière efficiente avec des parties restantes, non ablatées du substrat, produisant ainsi un couplage efficient entre ledit faisceau de rayonnement (32) et ledit substrat aboutissant à la génération d'un faisceau d'ions rapides.

17. Le procédé de la revendication 16, comprenant recevoir le faisceau de rayonnement (32) électromagnétique polarisé cohérent à haute puissance et diriger ledit faisceau de rayonnement (32) sur ladite surface dudit substrat cible (40) avec un angle de brillance désiré.

18. Le procédé de la revendication 17, dans lequel ledit angle de brillance est inférieure à 45° entre un axe de propagation de faisceau et une surface du substrat (40), de façon que ladite interaction entre ledit faisceau de rayonnement (32) et ledit substrat (40) permet la création des ions rapides d'énergie cinétique souhaitablement haute.

20

32

θ

Detector

Fast ions

Oriented
Target  40

Beam unit 90

Coherent Light source 92

FIG. 1A

FIG 1B

FIG 2

FIG 3A

FIG 3B

FIG 3C

30

32

20

34

40

42

41

33

60

56

51

56

44

50

55

54

52

FIG 4

FIG 5

FIG. 6A

FIG. 6B

FIG. 6C

FIG. 7

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- US 6906338 B

- US 2002090194 A1

### Non-patent literature cited in the description

- **BAGCHI.** Fast ion beams from intense, femtosecond laser irradiated nanostructured surfaces. *Applied Physics B,* 2007, vol. 88, 167-173
- **T. PALCHAN et al.** Efficient Coupling of High Intensity Short Laser Pulses into Snow Clusters. *Applied Physics Letters,* 2007, vol. 90, 041501

- **T. PALCHAN et al.** Generation of Fast Ions by an Efficient Coupling of High Power Laser Into Snow Nanotubes. *Applied Physics Letters,* 2007, vol. 91, 251501
- *Generation of Fast Ions by an Efficient Coupling of High Power Laser into Ice Nanotubes*